# EUROPEAN PATENT APPLICATION

(11) **EP 4 715 849 A1**
(43) Date of publication of application: **25.03.2026**
(21) Application number: 25315294.6
(22) Date of filing: 06.08.2025
(51) Int. Cl.: H01F 27/28, H03H 7/42

(54) **ELECTRONIC DEVICE**

(30) Priority: 24.09.2024 FR 2410189; 09.12.2024 EP 24315562
(71) Applicant: STMicroelectronics International N.V., 1228 Plan-les-Ouates, Geneva (CH)
(72) Inventor: Azevedo De Souza E Vecchia, Vinicius, 38240 MEYLAN (FR); Roux, Jocelyn, 38570 HURTIERES (FR)
(74) Representative: Cabinet Beaumont

(57) **Abstract**

The present disclosure relates to an electronic device (100) and method of generating two phase quadrature signals using such a device, comprising: a Balun-type circuit (110) comprising a primary branch (111) and a secondary branch (112); and a filter circuit (120) adapted to provide two signals in phase quadrature on two first nodes (IM100, IP100), wherein said secondary branch (112) is connected between said first nodes (IM100, IP100), and wherein a first inductor (Lp101) of said primary branch is magnetically coupled with at least a second inductor (L101, L102) of said filter circuit (120).

## Description

### Technical field

The present description relates to electronic systems and circuits, and more particularly to analog electronic systems and circuits suitable for processing data signals, such as high-frequency or radio-frequency signals. More specifically, the present description relates to a Balun-type circuit associated with a filter circuit.

### Background art

Balun-type circuits are used to link: a symmetrical transmission line (two-wire line or parallel printed lines) and an asymmetrical transmission line (coaxial cable or printed line onto a ground plane).

It would be desirable to at least partly improve certain aspects of known Balun-type circuits.

### Summary of Invention

There is a need for more efficient Balun-type circuits.

There is a need for more compact Balun-type circuits.

There is a need for Balun-type circuits that are easier to configure in terms of frequency and filtering features.

One embodiment addresses all or some of the drawbacks of known Balun-type circuits.

One embodiment provides an electronic device comprising:
- a Balun-type circuit comprising a primary branch and a secondary branch; and
- a filter circuit adapted to provide two signals in phase quadrature on two first nodes,

wherein said secondary branch is connected between said first nodes, and
wherein a first inductor of said primary branch is magnetically coupled with at least a second inductor of said filter circuit.

An embodiment provides a method of generating two phase quadrature signals using an electronic device:
- a Balun-type circuit comprising a primary branch and a secondary branch; and
- a filter circuit adapted to provide two signals in phase quadrature on two first nodes,

wherein said secondary branch is connected between said first nodes, and
wherein a first inductor of said primary branch is magnetically coupled with at least a second inductor of said filter circuit.

According to an embodiment, said filter circuit comprises two LC circuits coupled in anti-parallel between said first two nodes.

According to an embodiment, the coupling coefficient of said first inductor and said at least one second inductor is lower than 0.2, preferably lower than 0.1, preferably the closest to zero as possible considering the manufacturing constraints.

According to an embodiment, said filter circuit comprises two second inductors, and said two second inductors are magnetically coupled to each other.

According to an embodiment, the coupling coefficient of said second inductors is the highest as possible considering the manufacturing constraints, preferably greater than 0.6.

According to an embodiment, said secondary branch comprises two third inductors arranged in series.

According to an embodiment, the first inductor is magnetically coupled with at least one of said third inductors of said secondary branch.

According to an embodiment, the coupling coefficient of said first inductor and said at least one if said third inductors is not null, preferably greater than 0.2, preferably greater than 0.3.

According to an embodiment, at least one of said third inductors of said secondary branch is magnetically coupled with said at least second inductor.

According to an embodiment, the coupling coefficient of said third inductors and said at least one second inductor is comprised between -0.2 and to 0.2, preferably between -0.1 and 0.1, preferably the closest to zero as possible considering the manufacturing constraints.

According to an embodiment, said two third inductors are magnetically coupled to each other.

According to an embodiment, the coupling coefficient of said third inductors is the highest as possible considering the manufacturing constraints, preferably greater than 0.6.

According to an embodiment, said first, second, and third inductors are formed by inductive windings stacked one on top of the other.

### Brief description of drawings

The foregoing features and advantages, as well as others, will be described in detail in the following description of specific embodiments given by way of illustration and not limitation with reference to the accompanying drawings, in which:
Figure 1 illustrates an embodiment of a circuit associating a Balun-type circuit and a filter circuit;
Figure 2 illustrates a practical example of the embodiment of Figure 1; and
Figure 3 illustrates how to configurate the practical example of Figure 2.

### Description of embodiments

Like features have been designated by like references in the various figures. In particular, the structural and/or functional features that are common among the various embodiments may have the same references and may dispose identical structural, dimensional and material properties.

For the sake of clarity, only the operations and elements that are useful for an understanding of the embodiments described herein have been illustrated and described in detail.

Unless indicated otherwise, when reference is made to two elements connected together, this signifies a direct connection without any intermediate elements other than conductors, and when reference is made to two elements coupled together, this signifies that these two elements can be connected, or they can be coupled via one or more other elements.

In the following disclosure, unless indicated otherwise, when reference is made to absolute positional qualifiers, such as the terms "front", "back", "top", "bottom", "left", "right", etc., or to relative positional qualifiers, such as the terms "above", "below", "higher", "lower", etc., or to qualifiers of orientation, such as "horizontal", "vertical", etc.

Unless specified otherwise, the expressions "around", "approximately", "substantially" and "in the order of" signify within 10 % or 10°, and preferably within 5 % or 5°.

The described embodiments concern the use of a Balun-type circuit associated with a filter circuit providing signals in phase quadrature, meaning signals with a phase shift of n/2, meaning 90 degrees, between them. The filter circuit used here is of the LC PPF type, where LC stands for a combination of inductive element(s) and capacitor(s), and PPF for Poly-Phase Filter. The inductive elements are, for example, coils, inductive windings or inductors.

Moreover, the described embodiments are particularly adapted to be used in any kind of industrial markets where a voltage conversion is required. More particularly, such voltage converter circuit can be intended for:
- the automotive industry, for example in the domain of car electrification or the domain of advanced driver assistance systems (ADAS);
- the industrial domain, for example in the domain of green energy, in the domain of electrification of infrastructure, of the internet of things (IoT), and of smart homes, wherein power and energy consumption and the exchange of data are key element;
- the personal electronics industry, for example in the domain of mobile phone and of the internet of things (IoT), and in the domain of high speed-interface; and
- the communications equipment, computers and peripherals industry, for example in the domain of infrastructure and data centers, and in the domain of satellites in low earth orbit.

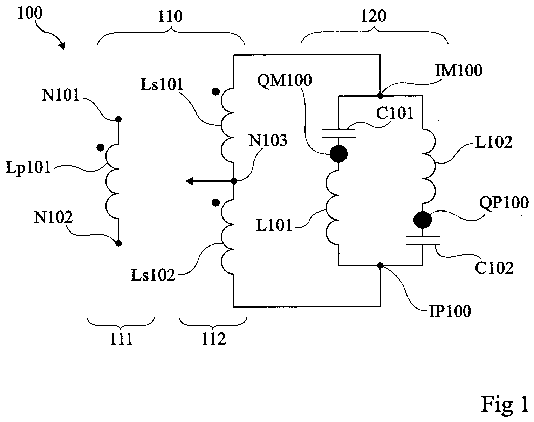

Figure 1 represents an embodiment of a circuit 100 associating a Balun-type circuit 110 and a filter circuit 120.

According to an embodiment, Balun-type circuit 110 comprises a primary branch 111 and a secondary branch 112.

According to an example, primary branch 111 comprises at least one inductor, or coil, Lp101. According to an example, a first terminal of inductor Lp101 is coupled, preferably connected, to a node N101, and a second terminal of inductor Lp101 is coupled, preferably connected, to a node N102.

According to an example, secondary branch 112 comprises at least one inductor coupling a node IM100 and a node IP100. In the represented embodiment, the secondary branch 112 comprises two inductors Ls101 and Ls102. Inductors Ls101 and Ls102 are coupled to each other in series between node IM100 and node IP100. According to an example, a first terminal of inductor Ls101 is coupled, preferably connected, to node IM100, and a second terminal of inductor Ls101 is coupled, preferably connected, to a node N103. According to an example, a first terminal of inductor Ls102 is coupled, preferably connected, to node N103, and a second terminal of inductor Ls102 is coupled, preferably connected, to node IP100. In other words, Inductors are coupled with a central tap.

According to an embodiment, filter circuit 120 is of the LC PPF type, where LC stands for a combination of inductive elements and capacitors, and PPF for Poly-Phase Filter. Filter circuit 120 comprises four nodes IM100, QP100, IP100 and QM100. According to an embodiment, if a signal is applied between nodes IM100 and IP100, nodes QP100 and QM100 are configured to provide the signal with a phase shift of ninety degrees. More particularly:
- the potential provided by node QP100 presents a phase shift of ninety degrees in comparison with the potential of node IP100;
- the potential provided by node IP100 presents a phase shift of ninety degrees in comparison with the potential of node QM100;
- the potential provided by node QM100 presents a phase shift of ninety degrees in comparison with the potential of node IM100; and
- the potential provided by node IM100 presents a phase shift of ninety degrees in comparison with the potential of node QP100.

According to an embodiment, filter circuit 120 comprises two LC circuits coupled in anti-parallel between said nodes IM100 and IP100.

According to an example, a first LC circuit comprises an inductor L101 and a capacitor C101. According to an example, a first terminal of inductor L101 is coupled, preferably connected, to node IP100, and a second terminal of inductor L101 is coupled to node QM100. According to an example, a first terminal of capacitor C101 is coupled, preferably connected, to node QM100, and a second terminal of capacitor C101 is coupled to node IM100.

According to an example, a second LC circuit comprises an inductor L102 and a capacitor C102. According to an example, a first terminal of inductor L102 is coupled, preferably connected, to node IM100, and a second terminal of inductor L102 is coupled to node QP100. According to an example, a first terminal of capacitor C102 is coupled, preferably connected, to node QP100, and a second terminal of capacitor C102 is coupled to node IP100.

According to an embodiment, at least one inductor of Balun-type circuit 110 is magnetically coupled to at least one inductor of filter circuit 120.

According to a first preferred embodiment, an inductor of the primary branch of Balun-type circuit 110 is magnetically coupled to at least one of the inductors of filter circuit 120, meaning inductor L101 and/or inductor L102. According to an embodiment, the coupling between inductor Lp101 and inductor L101 and/or inductor L102 may be a low coupling and having a coupling coefficient that is lower than 0.2, preferably lower than 0.1, preferably the closest to zero as possible considering the manufacturing constraints.

According to a second embodiment, which is compatible with the first preferred embodiment, the inductor Lp101 may be magnetically coupled to inductor Ls101 and/or inductor Ls102. According to an embodiment, the coupling between inductor Lp101 and inductor Ls101 and/or inductor Ls102 may be a moderate or high coupling, and having a coupling coefficient that is not null, preferably greater than 0.2, more preferably greater than 0.3.

According to a third embodiment, which is compatible with both the first preferred embodiment and the second embodiment, the inductors Ls101 and/or Ls102 may be magnetically coupled to inductor L101 and/or inductor L102. According to an embodiment, the coupling between inductor Lp101 and inductor Ls101 and/or inductor Ls102 may be a low coupling, i.e. a coupling coefficient that is comprised between -0.2 and 0.2, preferably between -0.1 and 0.1, preferably the closest to zero as possible considering the manufacturing constraints.

According to a fourth embodiment, which is compatible with the first, second and third embodiments, the inductors Ls101 and Ls102 may be magnetically coupled to each other. Any coupling value works (even zero) but the higher is the coupling (even 1), the higher is the mutual inductance between these inductors and the higher is the equivalent series inductance. This renders the circuit more compact. According to an embodiment, the coupling between inductor Ls101 and inductor Ls102 is greater than 0.6.

According to a fifth embodiment, which is compatible with the first, second, third and fourth embodiments, the inductors L101 and L102 may be magnetically coupled to each other. Any coupling value works (even zero) but the higher is the coupling (even 1), the higher is the mutual inductance between these inductors and the higher is the equivalent series inductance. This renders the circuit more compact. According to an embodiment, the coupling between inductor L101 and inductor L102 is greater than 0.6.

One advantage of using a circuit such as circuit 100 is that by adjusting the coupling between the inductors of circuit 100, it is possible to configure the feature of circuit 100, such as the center frequency of the quadrature signal provided by circuit 100.

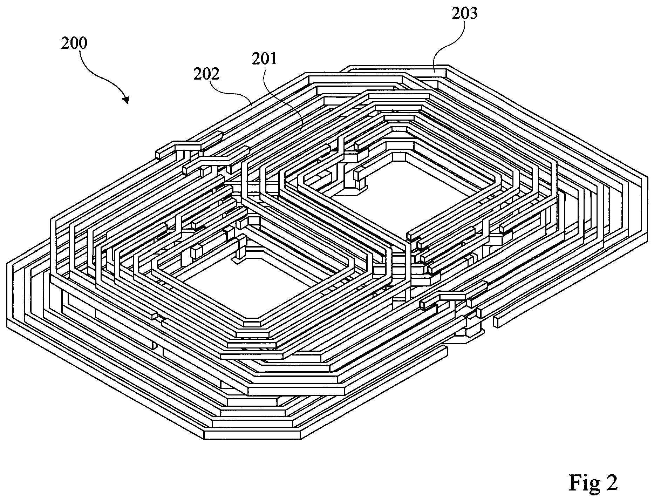

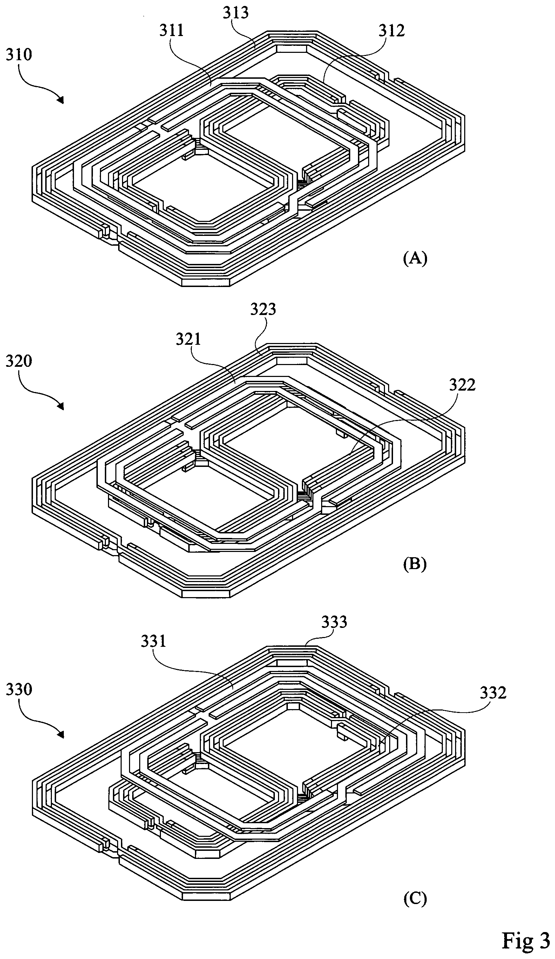

Another advantage of using a circuit such as circuit 100 is that it is more compact. Practical examples of circuit 100 are disclosed in relation with figures 2 and 3.

This disclosure also concerns a method of generating two phase quadrature signals using a circuit of the type of circuit 100.

Figure 2 is a perspective view of a practical example of a Balun-type circuit 200 of the type of circuit 100 described in relation with figure 1.

According to an example, circuit 200 is composed of at least three inductive windings 201, 202 and 203 forming the coils of the circuit. These three inductive windings are all stacked on top of the other.

According to an example, windings 201 are placed on the top of the circuit 200 and form the coils of the filter circuit of circuit 200. More particularly, windings 201 may be a practical example of coils L101 and L102 described in relation with figure 1. According to an example, windings 201 have an eight-shape (8-shape).

According to an example, windings 202 are placed below windings 201 and on top of windings 203 and form the coils of the secondary branch of the Balun-type circuit of circuit 200. More particularly, windings 202 may be a practical example of coils Ls101 and Ls102 described in relation with figure 1. According to an example, windings 203 form an eight-shape (8-shape) inductor stacked with windings 201 also forming an eight-shape inductor. The directions of the currents flowing in these 8-shape inductors condition the sign (positive or negative) of the coupling factor k.

According to an example, windings 203 are placed below windings 202 and form the coils of the primary branch of the Balun-type circuit of circuit 200. More particularly, windings 202 may be a practical example of coil Lp101 described in relation with figure 1. According to an example, windings 202 have a rectangular shape.

Figure 3 comprises three perspective view (A), (B) and (C) showing circuits 310, 320 and 330 of the type of circuit 200 described in relation with figure 2.

Such as circuit 200 of figure 2, each circuit 310, 320, and 323 comprises:
- first windings 311, 321, 331 forming coils of the secondary branch of the Balun-type circuit of circuits 310, 320, and 330;
- second windings 312, 322, 332 forming coils of the Poly-Phase circuit of circuits 310, 320, and 323; and
- third windings 313, 323, 333 forming coil of the primary branch of the Balun-type circuit of circuit 310, 320, and 330.

Differences between circuit 310, 320 and 330 are that each circuit 310, 320 and 330 has a different coupling coefficient concerning the coupling of the coils of the filter circuit and the coils of the secondary branch of the Balun-type circuit. More particularly, circuit 310 has a coupling coefficient of around -0.1, circuit 320 has a coupling coefficient of around 0, and circuit 330 has a coupling coefficient of around 0.1.

The value of the coupling coefficient results of the disposition of the second windings in respect with the third windings. The more the second and third windings are centered the more neutral is the coupling.

Various embodiments and variants have been described. Those skilled in the art will understand that certain features of these embodiments can be combined, and other variants will readily occur to those skilled in the art.

Finally, the practical implementation of the embodiments and variants described herein is within the capabilities of those skilled in the art based on the functional description provided hereinabove.

## Claims

1. An electronic device (100; 200; 310, 320, 330) comprising:
- a Balun-type circuit (110) comprising a primary branch (111) and a secondary branch (112); and
- a filter circuit (120) adapted to provide two signals in phase quadrature on two first nodes (IM100, IP100), wherein said secondary branch (112) is connected between said first nodes (IM100, IP100), and wherein a first inductor (Lp101) of said primary branch is magnetically coupled with at least a second inductor (L101, L102) of said filter circuit (120).

2. A method of generating two phase quadrature signals using an electronic device (100; 200; 310, 320, 330) comprising:
- a Balun-type circuit (110) comprising a primary branch (111) and a secondary branch (112); and
- a filter circuit (120) adapted to provide two signals in phase quadrature on two first nodes (IM100, IP100), wherein said secondary branch (112) is connected between said first nodes (IM100, IP100), and
wherein a first inductor (Lp101) of said primary branch is magnetically coupled with at least a second inductor (L101, L102) of said filter circuit (120).

3. The device according to claim 1, or method according to claim 2, wherein said filter circuit (120) comprises two LC circuits coupled in anti-parallel between said first two nodes.

4. The device according to claim 1 or 3, or method according to claim 2 or 3, wherein the coupling coefficient of said first inductor (Lp101) and said at least one second inductor (L101, L102) is lower than 0.2, preferably lower than 0.1, preferably the closest to zero as possible considering the manufacturing constraints.

5. The device according to any of claims 1, 3 or 4, or method according to any of claims 2 to 4, wherein said filter circuit (120) comprises two second inductors (L101, L102), and said two second inductors (L101, L102) are magnetically coupled to each other.

6. The device or the method according to claim 5, wherein the coupling coefficient of said second inductors (L101, L102) is the highest as possible considering the manufacturing constraints, preferably greater than 0.6.

7. The device according to any of claims 1, 3 to 6, or method according to any of claims 2 to 6, wherein said secondary branch (112) comprises two third inductors (Ls101, Ls102) arranged in series.

8. The device or method according to claim 7, wherein the first inductor (Lp101) is magnetically coupled with at least one of said third inductors (Ls101, Ls102) of said secondary branch.

9. The device or method according to claim 8, wherein the coupling coefficient of said first inductor (Lp101) and said at least one if said third inductors (Ls101, Ls102) is not null, preferably greater than 0.2, preferably greater than 0.3.

10. The device or method according to any of claims 7 to 9, wherein at least one of said third inductors (Ls101, Ls102) of said secondary branch is magnetically coupled with said at least second inductor (L101, L102).

11. The device or method according to claim 10, wherein the coupling coefficient of said third inductors (Ls101, Ls102) and said at least one second inductor (L101, L102) is comprised between -0.2 to 0.2, preferably between -0.1 and 0.1, preferably the closest to zero as possible considering the manufacturing constraints.

12. The device or method according to any of claims 7 to 11, wherein said two third inductors (Ls101, Ls102) are magnetically coupled to each other.

13. The device or method according to claim 12, wherein the coupling coefficient of said third inductors (Ls101, Ls102) is the highest as possible considering the manufacturing constraints, preferably greater than 0.6.

14. The device or method according to any of claims 7 to 13, wherein said first, second, and third inductors (Lp101, L101, L102, Ls101, Ls102) are formed by inductive windings stacked one on top of the other.
